# EUROPÄISCHE PATENTSCHRIFT

(11) **EP 2 235 406 B1**
(45) Veröffentlichungstag und Bekanntmachung des Hinweises auf die Patenterteilung: **11.07.2012**
(21) Anmeldenummer: 08862571.0
(22) Anmeldetag: 16.12.2008
(51) Int. Cl.: F16J 15/14, H05K 5/06

(54) **ABDICHTEN VON GEHÄUSEN MITTELS DICHTMASSE**
SEALING OF HOUSINGS BY MEANS OF SEALANTS
ETANCHAGE DE BOITIERS AU MOYEN D'UNE MASSE D'ETANCHAGE

(30) Priorität: 17.12.2007 DE 102007060760
(43) Veröffentlichungstag der Anmeldung: 06.10.2010
(73) Patentinhaber: Giesecke & Devrient GmbH, 81677 München (DE)
(72) Erfinder: NÖMMER, Franz, 84405 Dorfen (DE); ROSSBERGER, Antonius, 82404 Sindelsdorf (DE)
(86) Internationale Anmeldenummer: PCT/EP2008/010720
(87) Internationale Veröffentlichungsnummer: WO 2009/077164

(56) Entgegenhaltungen:
- DE-A1-102004 050 437
- DE-A1-102007 014 769
- FR-A- 1 368 561
- FR-A- 1 404 116
- GB-A- 2 115 084

## Beschreibung

Die Erfindung betrifft ein Verfahren zum Abdichten eines aus mehreren Gehäuseteilen zusammengesetzten Gehäuses gegen Eindringen von Staub zwischen Grenzflächen aneinander stoßender Gehäuseteile. Desweiteren betrifft die Erfindung einen dazu geeignet angepassten, mehrere Gehäuseteile umfassenden Gehäusebausatz. Die Erfindung ist von besonderer Bedeutung für Gehäuse, in denen Sensoren aufgenommen sind, die bei der Prüfung von Wertdokumenten eingesetzt werden.

Sensorgehäuse, insbesondere Gehäuse mit optischen Sensoren, müssen staubdicht ausgebildet sein, damit diese dauerhaft zuverlässige Messergebnisse liefern. Die Sensorgehäuse werden üblicherweise aus mehreren Gehäuseteilen zusammengesetzt, wobei aneinander stoßende Gehäuseteile mit Schaumgummi oder per Dichtmasse abgedichtet werden. Dazu werden die Grenzflächen der aneinander stoßenden Gehäuseteile vor dem Zusammenbau mit Dichtmasse, beispielsweise Silikon, versehen oder mit Schaumgummidichtungen ausgestattet. Dies kann aber sehr schwierig sein und ist teilweise unmöglich, wenn kompliziert geformte Gehäusebauteile aufeinander treffen, beispielsweise im Falle von Hinterschneidungen und anderen dreidimensionalen Kontaktgeometrien. Ein herkömmliches Sensorgehäuse ist bekannt aus z.B. DE 102004 050437A1.

Ein mit einer Dichtmasse abgedichtetes Gehäuse ist bekannt aus z.B. GB 2 115 084 A.

Aufgabe der vorliegenden Erfindung ist es daher, ein Verfahren zum Abdichten eines aus mehreren Gehäuseteilen zusammengesetzten Gehäuses gegen Eindringen von Staub vorzuschlagen, welches eine zuverlässige Abdichtung auch im Falle komplexer Kontaktgeometrien ermöglicht. Eine weitere Aufgabe besteht darin, einen zur Durchführung dieses Verfahrens geeigneten Gehäusebausatz anzugeben.

Das erfindungsgemäße Verfahren wird durch die Merkmale des Anspruchs 1 definiert und sieht vor, zunächst die gegeneinander abzudichtenden Gehäuseteile zusammenzusetzen und gegeneinander zu fixieren, so dass ein vollständiges Gehäuse oder zumindest ein Teilgehäuse gebildet wird, das später zu einem vollständigen Gehäuse ergänzt wird. Als vollständiges Gehäuse wird ein Gehäuse in vollständig geschlossener Bauweise bezeichnet, das keine staubdurchlässigen Öffnungen aufweist. Die Gehäuseteile werden derart zusammengesetzt, dass zwischen den gegeneinander abzudichtenden Gehäuseteilen, insbesondere an den aneinander stoßenden Grenzflächen zwischen den aneinander stoßenden Gehäuseteilen, mindestens ein geschlossener Kanal ausgebildet wird. Dazu können beispielsweise Nuten in einer der beiden oder in beiden aneinander stoßenden Grenzflächen vorgesehen sein, die dann im Zusammenwirken mit der jeweils anderen Grenzfläche bzw. der jeweils anderen Nut den geschlossenen Kanal bilden. Unter einem geschlossenen Kanal im Sinne der vorliegenden Erfindung ist ein Kanal zu verstehen, der einen rundherum geschlossenen Kanalquerschnitt besitzt. Mit anderen Worten verläuft der Kanal nach dem Zusammensetzen der aneinander stoßenden Gehäuseteile vollständig innerhalb der Gehäusewand. Das schließt nicht aus, dass der Kanal an seinem Anfang, und gegebenenfalls an seinem Ende, Öffnungen nach außen besitzt. So besitzt der Kanal zumindest eine Eintrittsöffnung und eine oder gegebenenfalls mehrere Austrittsöffnungen. Durch die Eintrittsöffnung wird, nachdem die Gehäuseteile zusammengesetzt und gegeneinander fixiert wurden, Dichtmasse in den Kanal eingefüllt. Die Dichtmasse wird dabei zwischen die aneinander stoßenden Grenzflächen der abzudichtenden Gehäuseteile eingebracht. Das Einfüllen der Dichtmasse wird so lange fortgesetzt, bis der Kanal über seine gesamte Länge mit Dichtmasse gefüllt ist.

Die beim Einfüllen der Dichtmasse aus dem Kanal verdrängte Luft kann entlang des Kanals und/ oder durch enge Ritzen zwischen den Grenzflächen entweichen. Dagegen kann die Dichtmasse aufgrund ihrer Oberflächenspannung nicht durch Ritzen zwischen den aneinander stoßenden Grenzflächen hindurch treten, sondern verteilt sich entlang des Kanals. Vorzugsweise besitzt der Kanal zumindest eine Austrittsöffnung, aus der die Dichtmasse austreten kann. Dies hat den Vorteil, dass anhand des Austritts von Dichtmasse aus der Austrittsöffnung in einfacher Weise visuell prüfbar ist, ob der Füllvorgang abgeschlossen ist. Sofern sich der Kanal in mehrere Kanalzweige verzweigt, ist vorzugsweise für jeden Kanalzweig mindestens eine derartige Austrittsöffnung vorgesehen. Im Falle solcher Verzweigungen ist es vorteilhaft, die Austrittsöffnungen der Kanalzweige mit einer im Vergleich zu dem Querschnitt des Kanalzweigs verjüngten Querschnittsfläche zu versehen, damit durch den verringerten Querschnitt der Dichtmassefluss verzögert wird. Auf diese Weise lassen sich alle Kanalzweige komplett und gleichmäßig mit Dichtmasse füllen. Zur weiteren Verbesserung des Auffüllens mehrerer Kanalzweige können auch mehrere Eintrittsöffnungen vorgesehen sein, z.B. jeweils eine für jeden Kanalzweig.

Mit der vorliegenden Erfindung lassen sich komplexeste Gehäuseteile zuverlässig staubdicht gegeneinander abdichten. So ist eine Abdichtung auch im Falle von Hinterschneidungen möglich, also beispielsweise in solchen Fällen, bei denen die den Kanal bildenden Grenzflächen während des Zusammenbaus nicht einfach aufeinander gesetzt werden können, sondern aneinander vorbei geschoben werden müssen, um die Gehäuseteile in Position zu bringen. In derartigen Fällen können herkömmliche Schaumgummidichtungen oder Silikondichtmassen nicht vor dem Zusammenbau an den Grenzflächen vorgesehen werden. Im Vergleich dazu wird bei dem erfindungsgemäßen Verfahren erst mit dem Zusammenbau der geschlossene Kanal ausgebildet, welcher dann nach dem Zusammenbau in einfacher Weise durch Befüllen mit Dichtmasse eine zuverlässige Dichtung herstellt.

Da die Dichtmasse erst nach dem Zusammensetzen des Gehäuses oder des Teilgehäuses eingespritzt wird, kann es beim Zusammensetzen der Gehäuseteile nicht zum Verschmieren der Dichtmasse kommen. Dies ist von besonderer Bedeutung bei hochwertigen Sensorgehäusen, insbesondere bei einem optischen Sensorgehäuse, das ein Fenster aufnimmt durch welches der Sensor Messsignale erfassen kann und welches sauber zu bleiben hat. Durch das erfindungsgemäße Verfahren kann ein Sensorfenster zuverlässig und sauber gegen das Sensorgehäuse abgedichtet werden. Beim Abdichten eines Sensorfensters wird der Kanal für die Dichtmasse vorzugsweise zwischen einer Nut im Sensorgehäuse und der Fläche des Fensters ausgebildet.

Das Gehäuse oder Teilgehäuse, für das das erfindungsgemäße Verfahren verwendet wird wird zur Aufnahme eines oder mehrerer Sensoren zur Prüfung von Wertdokumenten verwendet, die vorzugweise einer Maschine zur Wertdokumentbearbeitung eingesetzt werden. In den Sensorgehäusen können z.B. Messelemente von optischen und/oder magnetischen und/oder kapazitiven Sensoren angeordnet sein. Diese Sensoren sind dabei üblicherweise an einer Transportstrecke angeordnet, entlang der Wertdokumente an den Sensoren vorbeitransportiert werden.

Der Zusammenbau und die Fixierung der Gehäuseteile lassen sich optimieren, wenn die Gehäuseteile ineinandersteckbar sind. Alternativ oder zusätzlich zur Ineinandersteckbarkeit der Gehäuseteile sind die Gehäuseteile durch eine Schnappverbindung relativ zueinander fixierbar. Das kann für einfache Gehäuseteilgeometrien ausreichend sein. Alternativ oder ergänzend dazu, insbesondere wenn die Dichtmasse mit hohem Einspritzdruck in den Kanal eingefüllt wird, können die Gehäuseteile gegeneinander verschraubt oder in anderer Weise fest miteinander verbunden werden.

Erfindungsgemäß wird die Funktionsfähigkeit des in dem Gehäuse aufgenommenen Sensors überprüft, noch bevor die Dichtmasse in den Kanal eingefüllt wird. Fällt die Prüfung negativ aus, so kann das Gehäuse oder Teilgehäuse problemlos zerlegt werden, beispielsweise durch Lösen der relativen Fixierung der Gehäuseteile, die durch Ineinanderstecken und/ oder Schnappverbindungen und/oder Schrauben hergestellt wurde. Nach dem Zerlegen kann die Funktionsfähigkeit des Sensors und/ oder von Komponenten des Sensors hergestellt werden, gegebenenfalls einzelne Komponenten ersetzt werden, und das Gehäuse oder Teilgehäuse erneut zusammengesetzt werden. Das Füllen des Kanals mit Dichtmasse erfolgt dann erst nach erfolgreicher Funktionsüberprüfung. Dadurch wird ein weiterer mit der Erfindung erzielter Vorteil deutlich, der darin besteht, dass im Falle mangelhafter Funktionsfähigkeit des Sensors ein Entfernen von Dichtmasse und Reinigen der Grenzflächen im Zusammenhang mit der Demontage entfällt.

Als Dichtmasse kommt ein dauerelastisches und gut an den Grenzflächen haftendes Material in Betracht, insbesondere Silikon oder Acryl, soweit es keinen nennenswerten Volumenschwund aufweist. Sind empfindliche Einbauten vorhanden, so ist darauf zu achten, dass die Dichtmasse keine schädlichen Gase, wie beispielsweise Essigsäure, abgibt, weil solche Gase empfindliche Oberflächen angreifen können. Die Auswahl der verwendeten Dichtmasse hängt auch vom Kanalquerschnitt und der Kanallänge ab. Je länger der Kanal ist und/oder je kleiner der Kanalquerschnitt ist, desto fließfähiger muss das Dichtmassematerial sein.

Bei der Verwendung von Silikon als Dichtmasse hat sich im Falle eines optischen Sensorgehäuses üblicher Baugröße ein Querschnitt von mindestens 10 mm², vorzugsweise von mindestens 15 mm², insbesondere etwa 16 mm², als optimal herausgestellt. Das Verhältnis von Höhe und Breite des Kanalquerschnitts, oder allgemeiner ausgedrückt, das Verhältnis X der beiden extremsten Querschnittsabmessungen, sollte jedenfalls in den Längenabschnitten des Kanals durchgehend 0,8 < X < 1,2 und vorzugsweise etwa X = 1 betragen. An Kreuzungs- oder Verzweigungsstellen des Kanals kann das Querschnittsverhältnis anders gewählt werden. Der ideale Kanalquerschnitt ist quadratisch oder insbesondere kreisförmig. Dabei muss der Kanalquerschnitt nicht zwingenderweise durch die Grenzflächen zweier aneinander stoßender Gehäuseteile gebildet werden. Es ist auch möglich, dass der Kanal durch drei oder mehr aneinander grenzende Gehäuseteile gebildet wird.

Nachfolgend wird die Erfindung beispielhaft anhand der begleitenden Zeichnungen beschrieben. Darin zeigen:
- Figur 1a: ein aus mehreren Gehäuseteilen bestehendes Teilgehäuse,
- Figur 1b: das Teilgehäuse aus Figur 1 mit einer fehlenden Wand vor dem Abdichten mittels Dichtmasse,
- Figur 1c: den mit Dichtmasse gefüllten Kanal des Teilgehäuses aus Figur 1a,
- Figur 2a: ein aus zwei miteinander zu verbindenden Gehäuseteilen bestehendes Gehäuse vor dem Zusammenbauen und Abdichten,
- Figur 2b: das Gehäuse aus Figur 2a nach dem Zusammenbauen und Abdichten, teilweise im Schnitt,
- Figuren 3abis 3c: verschiedene zwischen mehr als zwei aneinander grenzenden Gehäuseteilen gebildete Dichtungskanäle im Querschnitt.

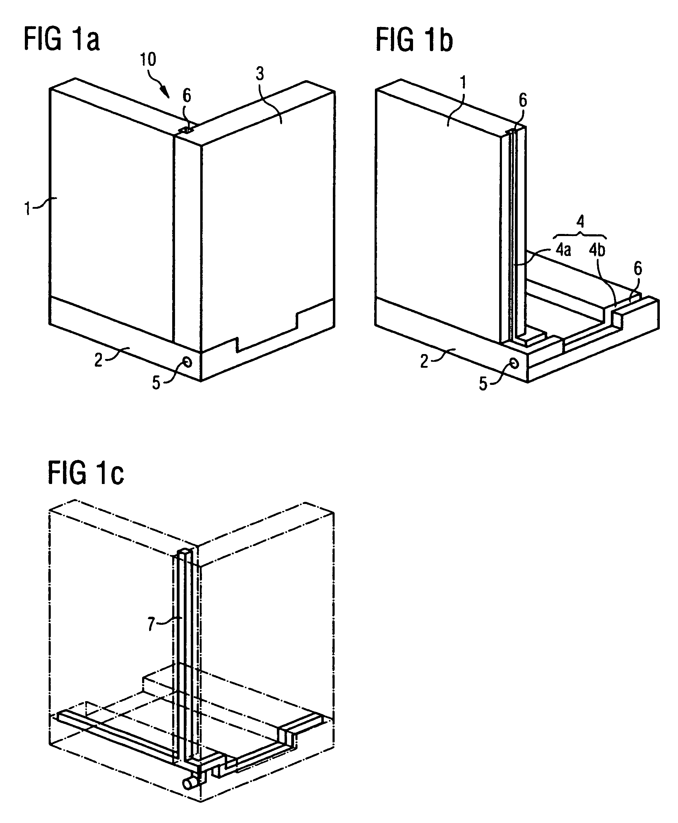

Figur 1 zeigt ein Teilgehäuse 10 umfassend drei Gehäuseteile 1, 2 und 3 im zusammengesetzten Zustand. Figur 1b zeigt dasselbe Teilgehäuse ohne das Gehäuseteil 3. In Figur 1b ist der Verlauf zweier Kanalzweige 4a, 4b eines Dichtmassekanals 4 zu erkennen. Die Kanalzweige 4a, 4b sind als Nuten in den aneinander stoßenden Grenzflächen der Gehäuseteile 1, 2 und 3 realisiert. Mit dem Gehäuseteil 3 ergibt sich somit ein geschlossener Dichtmassekanal 4. Der Dichtmassekanal 4 hat eine Eintrittsöffnung 5 und drei Austrittsöffnungen 6, von denen in Figur 1a eine und in Figur 1b zwei zu erkennen sind.

Die Dichtmasse wird in die Eintrittsöffnung 5 mit gängigen Dispensern und Düsen appliziert, wie sie von den Dichtmasseherstellern angeboten werden. Beispielsweise kann die Dichtmasse mittels eines mit Druckluft betriebenen Dispensers (z.B. Fa. GLT) in die Eintrittsöffnung 5 eingespritzt werden. Die Verarbeitungsbedingungen, insbesondere die Sauberkeit der Nuten, Verarbeitungstemperatur und Verarbeitungszeit, sind so einzuhalten, wie sie vom Dichtmassehersteller vorgegeben werden. Um eine einfache Handhabung zu ermöglichen, wird vorzugsweise eine Dichtmasse gewählt, die bei Raumtemperatur verarbeitbar ist. Idealerweise sind die Form und der Querschnitt der Eintrittsöffnung 5 an die Form und an den Querschnitt des Dispensers angepasst und dementsprechend vorzugsweise kreisförmig.

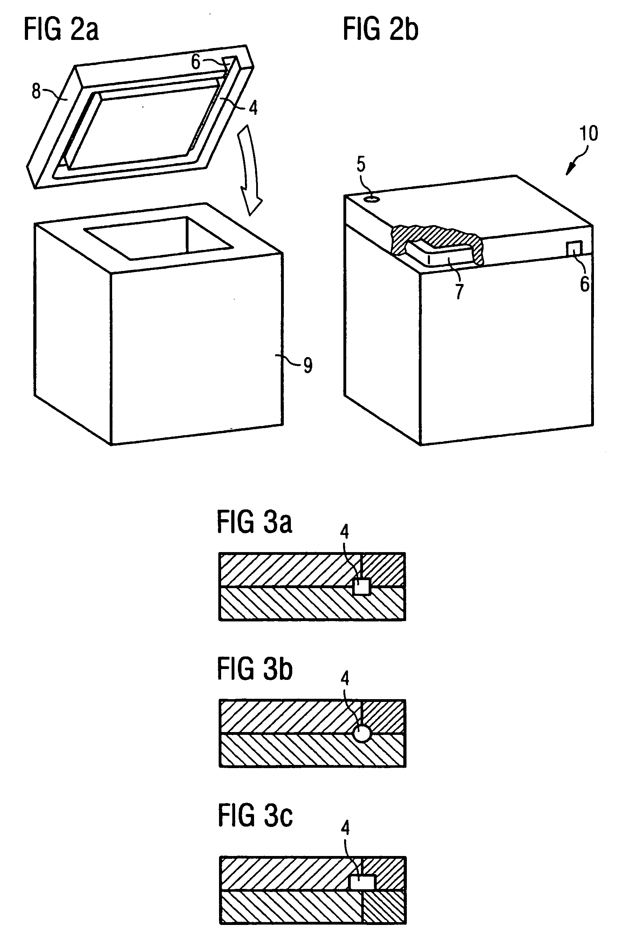

Sofern nur eine Austrittsöffnung 6 vorgesehen ist (siehe nachfolgend Figuren 2a und 2b) ist die Querschnittsgeometrie der Austrittsöffnung unbedeutend. Sind aber, wie bei dem vorliegenden Ausführungsbeispiel, Verzweigungen des Dichtmassekanals 4 in mehrere Kanalzweige vorgesehen, die jeweils an ihrem Ende eine Austrittsöffnung 6 zum Austreten überschüssiger Dichtmasse besitzen, so wird der Querschnitt der Austrittsöffnungen vorzugsweise kleiner ausgebildet als die engsten Querschnitte des Kanals 4 und der Kanalzweige 4a, 4b. Der Querschnitt der Austrittsöffnungen der Kanalzweige ist in diesem Fall vorzugsweise auch geringer als der Querschnitt der Eintrittsöffnung. Durch die geringere Querschnittsfläche der Austrittsöffnungen erhöht sich der Fließwiderstand, so dass sich beim Einfüllen der Dichtmasse zunächst der Kanal 4 vollständig mit Dichtmasse füllt bevor überschüssige Dichtmasse aus den Austrittsöffnungen austritt. Sobald dies der Fall ist, kann davon ausgegangen werden, dass das Auffüllen des Kanals 4 und der Kanalzweige 4a, 4b abgeschlossen ist. Figur 1c zeigt die sich letztendlich ergebende Dichtung 7. Je nach Art der Dichtmasse kann es erforderlich sein, diese aushärten zu lassen, bevor das Gehäuse zum Einsatz kommt.

Figur 2a und 2b zeigen den zuvor beschriebenen Prozess der Gehäuseabdichtung an einem zweiten, einfachen Beispiel. Hier wird ein Deckel 8 auf einen behälterartigen Gehäusekörper 9 aufgesetzt. Es kann sich dabei beispielsweise um ein optisches Sensorgehäuse mit einem (hier nicht dargestellten) Fenster und einem in dem Gehäusekörper 9 aufgenommenen optischen Sensor (ebenfalls nicht dargestellt) handeln, der durch das Fenster tretende Lichtintensitäten erfasst. Die Abmessungen der Sensorgehäuse liegen typischerweise im Bereich 5 cm - 25 cm. Figur 2a zeigt den Gehäusedeckel 8 mit einer darin eingeformten Nut, die im Zusammenwirken mit dem Gehäusekörper 9 den Kanal 4 bildet. Eine Eintrittsöffnung 5 ist oben im Deckel leicht zugänglich vorhanden. Von dieser Eintrittsöffnung 5 erstrecken sich zwei Kanalzweige, die an einer seitlichen Austrittsöffnung 6 zusammentreffen. In die Eintrittsöffnung 5 wird Dichtmasse blasenfrei eingespritzt. Sobald Dichtmasse aus der Austrittsöffnung 6 austritt, ist dies ein Zeichen für einen erfolgreichen Füllvorgang. Die Austrittsöffnung 6 ist so angeordnet, dass sie von außen gut sichtbar ist. Die teilweise Schnittdarstellung in Figur 2b zeigt die durch die Dichtmasse gebildete Dichtung 7.

Figuren 3a bis 3c zeigen schematisch mehrere Möglichkeiten, wie der Dichtmassekanal 4 durch mehr als zwei, hier durch drei oder vier, Gehäuseteile gebildet werden kann. Dabei kann der Gehäusequerschnitt quadratisch, kreisrund oder rechteckig sein oder auch andere Formen annehmen.

## Patentansprüche

1. Verfahren zum Abdichten eines mehrere Gehäuseteile (1, 2, 3; 8, 9) umfassenden Gehäuses (10), in dem ein Sensor zur Prüfung von Wertdokumenten aufgenommen ist, gegen Eindringen von Staub, wobei zumindest zwei der Gehäuseteile, die aneinander stoßen, mittels Dichtmasse (7) gegeneinander abgedichtet werden, umfassend die Schritte:
a) Zusammensetzen und Fixieren von mehreren der Gehäuseteile (1, 2, 3; 8, 9) zur Bildung des Gehäuses (10) oder eines Teilgehäuses (10) derart, dass zwischen den gegeneinander abzudichtenden Gehäuseteilen mindestens ein geschlossener Kanal (4) ausgebildet wird, der zumindest eine Eintrittsöffnung (5) für die Dichtmasse (7) aufweist, und Prüfen der Funktionsfähigkeit des in dem Gehäuse oder Teilgehäuse aufgenommenen Sensors und/oder von in dem Gehäuse oder Teilgehäuse aufgenommenen Komponenten des Sensors, und
b) Füllen des mindestens einen Kanals (4) mit Dichtmasse (7) durch die mindestens eine Eintrittsöffnung (5) hindurch, wobei das Füllen des Kanals (4) mit Dichtmasse (7) erst nach erfolgreicher Funktionsüberprüfung des Sensors erfolgt.

2. Verfahren nach Anspruch 1, **dadurch gekennzeichnet, dass** der Kanal (4) mindestens eine Austrittsöffnung (6) für die Dichtmasse (7) aufweist, deren Querschnittsfläche insbesondere kleiner ist als eine engste Kanalquerschnittsfläche, wobei der Schritt des Füllens vorzugsweise fortgesetzt wird, bis die Dichtmasse (7) an allen der mindestens einen Austrittsöffnung (6) austritt.

3. Verfahren nach einem der Ansprüche 1 bis 2, **dadurch gekennzeichnet, dass** als Dichtmasse (7) ein dauerelastisches Material, insbesondere Silikon oder Acryl, verwendet wird.

4. Verfahren nach einem der Ansprüche 1 bis 3, **dadurch gekennzeichnet, dass** der Kanal (4) derart ausgebildet wird, dass das Längenverhältnis X der beiden extremsten Abmessungen eines Kanalquerschnitts in den Längenabschnitten des Kanals 0,8 < X < 1,2 beträgt, wobei der Kanalquerschnitt vorzugsweise so ausgebildet wird, dass er mindestens 10 mm², vorzugsweise mindestens 15 mm² beträgt.

5. Verfahren nach einem der Ansprüche 1 bis 4, **dadurch gekennzeichnet, dass** der Kanal genau eine Eintrittsöffnung (5) zum Einfüllen der Dichtmasse (7) aufweist und dass beim Zusammensetzen und Fixieren der Gehäuseteile ein einziger, gegebenenfalls verzweigter (4a, 4b) Kanal (4) ausgebildet wird.

6. Verfahren nach einem der Ansprüche 1 bis 5, **dadurch gekennzeichnet, dass**, falls die Prüfung der Funktionsfähigkeit negativ ausfällt, das Gehäuse (10) oder Teilgehäuse (10) zerlegt wird und der Schritt a) erneut durchgeführt wird.

7. Verfahren nach einem der Ansprüche 1 bis 6, **dadurch gekennzeichnet, dass** in dem Gehäuse (10) oder Teilgehäuse (10) ein optischer Sensor aufgenommen ist, wobei zumindest eines der Gehäuseteile mit einem Fenster ausgestattet wird oder ein Fenster ist.

8. Verfahren nach einem der Ansprüche 1 bis 7, **dadurch gekennzeichnet, dass** für den Fall des Vorhandenseins von mindestens einer Austrittsöffnung (6) die Dichtmasse (7) die Austrittsöffnung (6) verschließt.

9. Verfahren nach einem der Ansprüche 1 bis 8, wobei das Gehäuse oder Teilgehäuse gebildet ist aus einem Gehäusebausatz, der **gekennzeichnet ist durch** Steckverbindungen und/oder Schnappverbindungen an zumindest einem der mehreren Gehäuseteile, so dass die Gehäuseteile **durch** Ineinanderstecken relativ zueinander fixierbar sind oder **durch** Schraubverbindungen an zumindest einem der mehreren Gehäuseteile, so dass die Gehäuseteile durch Verschrauben relativ zueinander fixierbar sind

## Claims

1. A method for sealing against the penetration of dust a housing (10) comprising several housing members (1, 2, 3; 8, 9) and in which there is received a sensor for checking value documents, wherein at least two of the housing members that abut are mutually sealed by means of sealing compound (7), comprising the steps of:
a) assembling and fixing several of the housing members (1, 2, 3; 8, 9) for forming the housing (10) or a partial housing (10) such that between the housing members to be mutually sealed there is formed at least one closed channel (4) which has at least one inlet opening (5) for the sealing compound (7), and checking the functional capability of the sensor received in the housing or partial housing and/or of components of the sensor that are received in the housing or partial housing, and
b) filling the at least one channel (4) with sealing compound (7) through the at least one inlet opening (5), whereby the filling of the channel (4) with sealing compound (7) is only effected after a successful function check.

2. The method according to claim 1, **characterized in that** the channel (4) has at least one outlet opening (6) for the sealing compound (7) whose cross-sectional area is in particular smaller than a narrowest channel cross-sectional area, wherein the filling step is preferably continued until the sealing compound (7) exits at all of the at least one outlet opening (6).

3. The method according to claim 1 or 2, **characterized in that** the sealing compound (7) employed is a permanently elastic material, in particular silicone or acrylic.

4. The method according to any of claims 1 to 3, **characterized in that** the channel (4) is formed such that the length ratio X of the two most extreme dimensions of a channel cross section in the length portions of the channel is 0.8 < X < 1.2, whereby the channel cross section is preferably so formed that it is at least 10 mm², preferably at least 15 mm².

5. The method according to any of claims 1 to 4, **characterized in that** the channel has exactly one inlet opening (5) for the filling in of sealing compound (7) and that upon assembling and fixing of the housing members there is formed a single, optionally branched (4a, 4b), channel (4).

6. The method according to any of claims 1 to 5, **characterized in that** if the check of functional capability turns out negative, the housing (10) or partial housing (10) is disassembled and step a) is carried out again.

7. The method according to any of claims 1 to 6, **characterized in that** in the housing (10) or partial housing (10) there is received an optical sensor, wherein at least one of the housing members is equipped with a window or is a window.

8. The method according to any of claims 1 to 7, **characterized in that** in the case of the presence of at least one outlet opening (6), the sealing compound (7) closes the outlet opening (6).

9. The method according to any of claims 1 to 8, wherein the housing or partial housing is formed of a housing kit which is **characterized by** slip-in connections and/or snap connections on at least one of the several housing members, so that the housing members are fixable relative to each other by being slipped into each other or by screw connections on at least one of the several housing members, so that the housing members are fixable relative to each other by being screwed together.

## Revendications

1. Procédé d'étanchement d'un boîtier (10) comprenant plusieurs parties de boîtier (1, 2, 3; 8, 9) dans lequel est hébergé un capteur destiné à l'examen de documents de valeur, contre la pénétration de poussière, au moins deux des parties de boîtier contiguës étant étanchéifiées l'une par rapport à l'autre au moyen de mastic d'étanchéité (7), comprenant les étapes :
a. assemblage et fixation de plusieurs des parties de boîtier (1, 2, 3; 8, 9) pour constituer le boîtier (10) ou un boîtier partiel (10) de telle manière qu'au moins un conduit fermé (4) est pratiqué entre les parties de boîtier à étanchéifier l'une par rapport à l'autre, lequel conduit comportant au moins un orifice d'entrée (5) pour le mastic d'étanchéité (7), et examen de la capacité de fonctionnement du capteur hébergé dans le boîtier ou la partie de boîtier et/ou de composants du capteur hébergés dans le boîtier ou la partie de boîtier, et
b. remplissage du au moins un conduit (4) avec du mastic d'étanchéité (7) à travers le au moins un orifice d'entrée (5), le remplissage du conduit (4) avec du mastic d'étanchéité (7) n'ayant lieu qu'après vérification aboutie du fonctionnement du capteur.

2. Procédé selon la revendication 1, **caractérisé en ce que** le conduit (4) comporte pour le mastic d'étanchéité (7) au moins un orifice de sortie (6) dont la surface de section transversale est notamment inférieure à une surface de section transversale du conduit la plus étroite, l'étape du remplissage étant de préférence poursuivie jusqu'à ce que le mastic d'étanchéité (7) sorte à tous des au moins un orifice de sortie (6).

3. Procédé selon une des revendications de 1 à 2, **caractérisé en ce que** c'est un matériau élastique permanent, notamment du silicone ou de l'acrylique, qui est utilisé en tant que mastic d'étanchéité (7).

4. Procédé selon une des revendications de 1 à 3, **caractérisé en ce que** le conduit (4) est réalisé de telle manière que le rapport de longueur X des deux dimensions les plus extrêmes d'une section de conduit dans les tronçons longitudinaux du conduit est de 0,8 < X < 1,2, la section de conduit étant de préférence réalisée de telle manière qu'elle est d'au moins 10 mm², de préférence d'au moins 15 mm².

5. Procédé selon une des revendications de 1 à 4, **caractérisé en ce que** le conduit comporte exactement un orifice d'entrée (5) pour introduire le mastic d'étanchéité (7) et **en ce qu'**un unique conduit (4) le cas échéant ramifié (4a, 4b) est pratiqué lors de l'assemblage et de la fixation des parties de boîtier.

6. Procédé selon une des revendications de 1 à 5, **caractérisé en ce que**, si l'examen de la capacité de fonctionnement aboutit à un résultat négatif, le boîtier (10) ou boîtier partiel (10) est démonté et l'étape a) est exécutée à nouveau.

7. Procédé selon une des revendications de 1 à 6, **caractérisé en ce qu'**un capteur optique est hébergé dans le boîtier (10) ou boîtier partiel (10), au moins une des parties de boîtier étant pourvue d'une fenêtre ou étant une fenêtre.

8. Procédé selon une des revendications de 1 à 7, **caractérisé en ce que**, pour le cas de l'existence d'au moins un orifice de sortie (6), le mastic d'étanchéité (7) obture l'orifice de sortie (6).

9. Procédé selon une des revendications de 1 à 8, le boîtier (10) ou boîtier partiel étant constitué à partir d'un kit de boîtier qui est **caractérisé par** des raccords à fiches ou à encliquetage à au moins une des plusieurs parties de boîtier de telle manière que les parties de boîtier peuvent être fixées entre elles par emboîtement, ou par des raccords à vis à au moins une des plusieurs parties de boîtier de telle manière que les parties de boîtier peuvent être fixées entre elles par vissage.
